# EUROPEAN PATENT SPECIFICATION

(11) **EP 0 708 985 B1**
(45) Date of publication and mention of the grant of the patent: **27.08.2003**
(21) Application number: 95916859.2
(22) Date of filing: 04.05.1995
(51) Int. Cl.: H01L 21/56, B29C 45/58

(54) **APPARATUS FOR ENCAPSULATING WITH PLASTIC A LEAD FRAME WITH CHIPS**
ANORDNUNG ZUM EINKAPSELN EINES LEITERRAHMENS FÜR CHIPS MIT KUNSTSTOFF
APPAREIL POUR ENROBER DE MATIERE PLASTIQUE UNE GRILLE DE CONNEXION A PUCES

(30) Priority: 09.05.1994 NL 9400768
(43) Date of publication of application: 01.05.1996
(73) Proprietor: FICO B.V., 6921 RW Duiven (NL)
(72) Inventor: PETERS, Hendrikus, Johannes, Bernardus, NL-6942 GP Didam (NL)
(74) Representative: Van den Heuvel, Henricus Theodorus
(86) International application number: NL9500163
(87) International publication number: WO95031004

(56) References cited:
- WO-A-93/11925
- PATENT ABSTRACTS OF JAPAN vol. 012, no. 254 (E-634) 16 July 1988 & JP,A,63 041 035 (MITSUBISHI ELECTRIC CORP.) 22 February 1988

## Description

The invention relates to an apparatus for encapsulating with plastic lead frames according the preamble of claim 1.

Such an apparatus is known from the the Japanese patent 63 041 035 (patent abstracts vol. 012, no. 254). This patent provides a plunger for a transfer molding press comprising an annular groove for shaping a resin ring opened to a head outer circumferential surface to the plunger. The annular groove communicates with a resin path that is opened to a head nose surface in the plunger. The resin path is opened at a central section of a head nose surface in the plunger and runs internal through the plunger to connect to the annular groove. The construction is designed for centring the plunger.

A similar apparatus is known from EP-A-0 428 792.

The flow of resin through the resin path after one or more production strokes will be blocked. This is not a problem for the function of centring the plunger but despite a close fitting of the plunger in the cylinder there is the danger of liquid encapsulating material running along the wall of the plunger as the resin in the annular groove will not be replenished. The resin in the annular groove will cure making it impossible to allow a continuous flow of resin through the resin path in the plunger.

The invention has the object of providing a solution to this problem. This is achieved according to characterising part of claim 1.

With the steps according to the invention the following is achieved. When a production stroke is performed and a pellet-shaped piece of encapsulating material is placed on the plunger head, which material becomes fluid through exerting of pressure and under the influence of heat, the encapsulating material will reach and fill the peripheral groove through the at least one flow channel runs in the outer wall of the plunger. The filled groove then serves as sealant of the plunger relative to the inner wall of the cylinder. At the end of the production stroke the plunger moves outside the upper edge of the cylinder. During the return movement the outer layer of the groove and the outer layer of the cured encapsulating material in the at least one flow channel will be scraped off by the scraping edge of the cylinder. During a subsequent production stroke encapsulating material will be able to move through the clearance between the plunger and the inner wall of the cylinder and once again replenish the scraped-off outer layer of the encapsulating material in the groove.

A self-regulating sealing system is thus obtained.

The flow channel is preferably of swallowtail shape in order to ensure securing of the cured quantity of encapsulating material into the groove.

The scraping off of cured encapsulating material located between the plunger and the inner wall of the cylinder can be stimulated further in a combination with a scraping structure of helically running grooves on the outer wall of the cylinder. Such a scraping structure on itself is known from the International patent application WO 93/11925.

Further advantages and special features will become apparent from the description following hereinbelow of the drawings, in which:
Fig. 1 shows a perspective view with broken away parts of the apparatus according to the invention,
Fig. 2 shows on large scale a detail of the lowermost part of the apparatus of fig. 1,

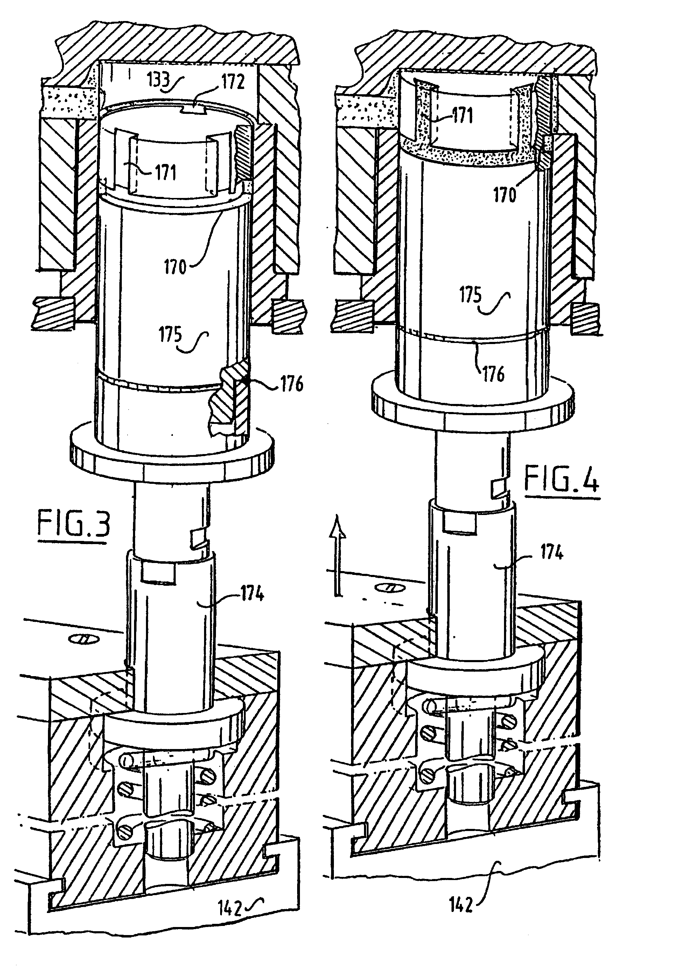

Fig. 3 and 4 are cross sectional views of the plunger and the plunger driving drive rod,

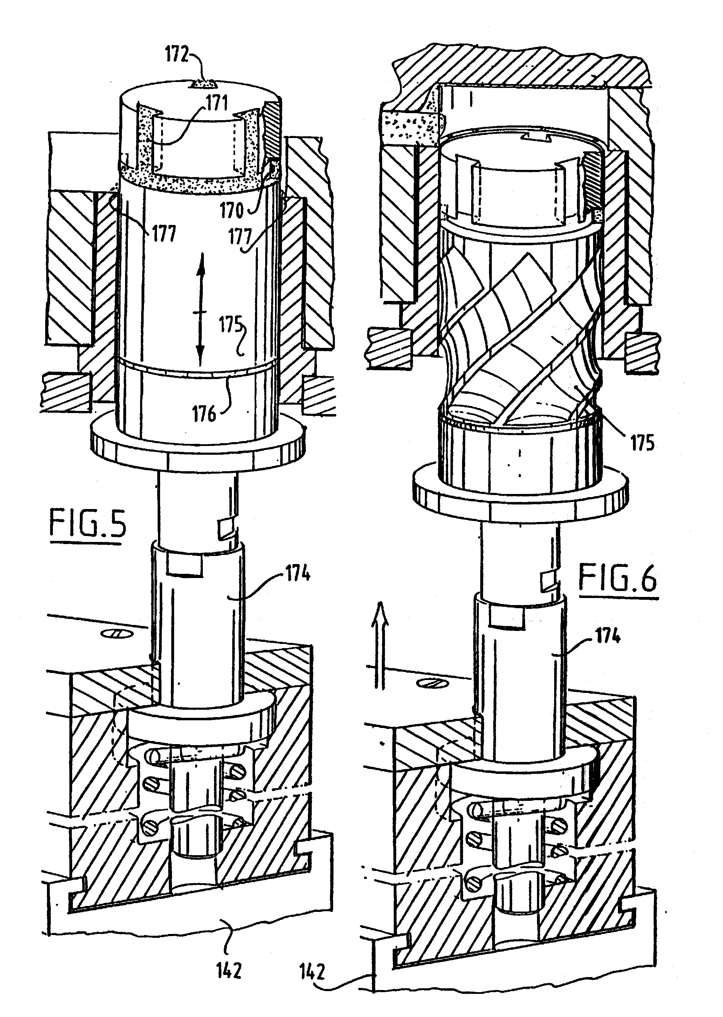

Fig. 5 shows a view of the head end of the plunger according to the invention, and
Fig. 6 is a cross sectional view of an alternative embodiment of the invention.

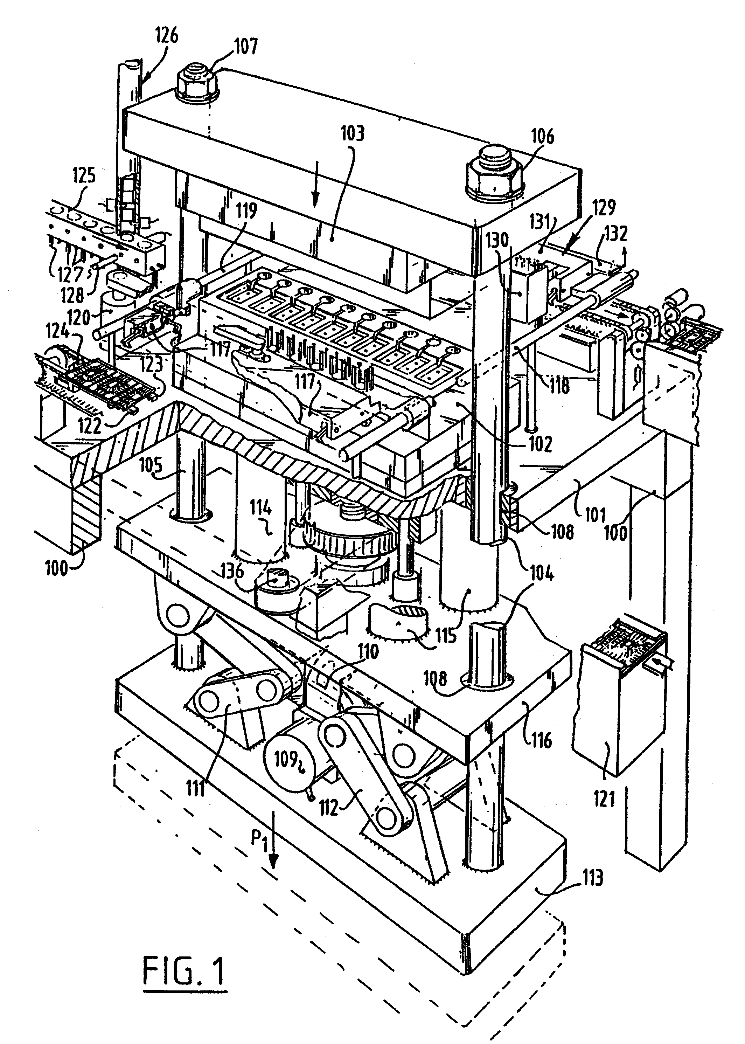

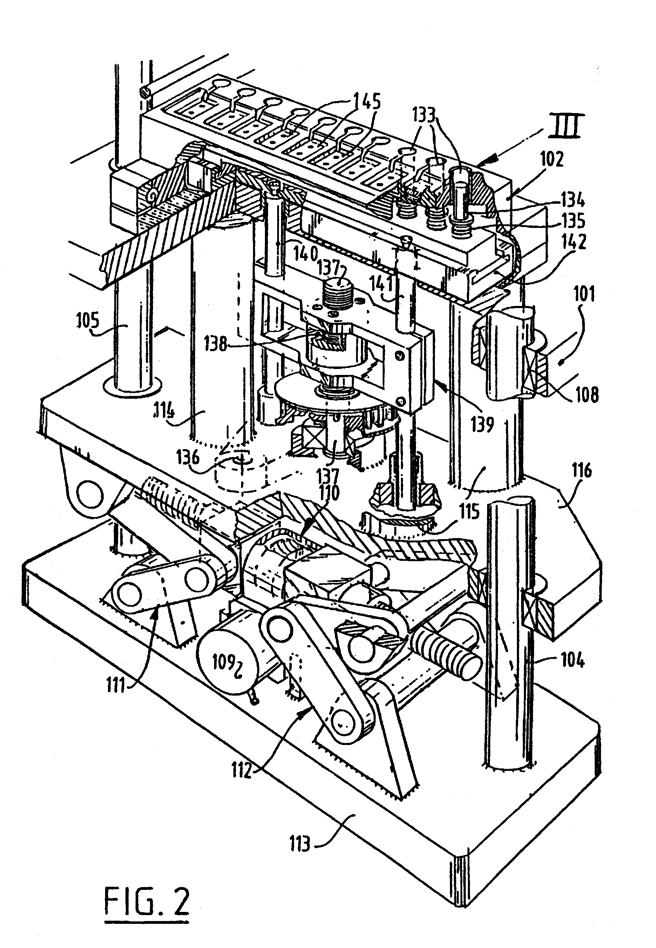

A description of the moulding apparatus according to the invention will be given with reference to fig. 1 and 2.

Mounted on the frame 100 of the machine is a fixedly positioned table 101. The table 101 bears a fixed lower mould half 102. The upper mould half 103 is movable relative to the lower half 102 using pull rods 104, 105 which are connected to the upper half 103 by the respective nut connections, 106, 107. The pull rods 104, 105 are movable relative to the fixed table 101 via bearings, for example 108.

The driving of the upper half of the mould 103 takes place from an electric motor 109. The angle lever systems 111, 112 are driven by means of the worm box 110. The angle lever systems are coupled on the one side to a movable underplate 113 and on the other side to a plate 116 fixedly connected to the table 101 by means of columns 114, 115. When the electric motor rotates the underplate 113 is moved vertically, for example in the direction of the arrow P1, which movement is transmitted via the pull rods 104, 105 onto the upper mould half 103. At the end of the stroke the arms of the angle lever system 111, 112 lie practically in one line so that a very great closing force is achieved. The input carriage 117 is movable over the guide rails 118, 119. The driving of the input carriage 117 takes place from the electric motor 120.

Lead frames are supplied from a supply cassette and are carried up over belts 122, 123 as far as a stop 124. During the position of the input carriage outside the mould the input carriage is filled from a so-called pellet-filling carriage 125 with pellet-shaped encapsulating material which is taken from a supply reservoir 126. For a reliable take-over of pellet-shaped encapsulating material by the input carriage 117 from the pellet transporting carriage 125 use is made in both carriages of pin-shaped guiding means 127. The mutual movements are controlled using a sensor 128.

The cleaning-discharge unit 129 is likewise movable over the rails 118, 119 between the position outside the mould die and the position inside the mould die. The unit 129 consists of a cleaning-brushing apparatus 130 and a discharge member 131. The cleaning apparatus 130 brushes both mould halves after use and simultaneously sucks up brushed-off remnants. Co-acting with the unit is a break-off plate 132 which subjects the finished product to an after-processing.

As can be seen in fig. 2, the cavities 133 in the lower half 102 of the mould are each provided with a plunger 134 which is biased by a spring 135 such that the position of the plunger is adapted to the quantity of encapsulating material in the relevant cavities 133. The plungers are driven from an electric motor which drives a screwed rod 137 via the speed control 136. A nut 138 is placed on the screwed rod so that the rotating movement is converted into a vertically directed movement of the frame 139. Fixedly coupled to the frame are the drive rods 140, 141 for the plunger bracket 142 which in turn drives the plungers.

Pellet-shaped encapsulating material is compressed during the ascending movement of the plunger 175 and transported via a runner to the cavity 145 in the lower half of the mould where the chip is arranged.

According to the invention the plunger 175 is provided at a relatively short distance from the head end with a groove 170 which is connected to the head end by means of flow channels, for instance 171, 172. The flow channels 171, 172 preferable take a swallowtail form, thus preventing breaking away and fouling due to the breaking away of the encapsulating material. According to an alternative embodiment the plunger 175 is provided with helical grooves, the depth of which increases as seen from the drive side of the plunger 175.

The drive rod 174 of plunger 175 is connected to plunger 175 by means of welds 176.

The apparatus according to the invention operates as follows. When a production stroke is performed a pellet-shaped piece of encapsulating material is placed on the head end of the plunger 175. When the stroke is performed the encapsulating material becomes plastic and moves through the flow channels 171, 172 to the groove 170 in the plunger 175. The groove 170 is wholly filled. When the product is ejected the groove 170 of plunger 175 rises above the cylinder such that during the return stroke the material in the groove 170 is scraped off on the sharp cylinder edge. After performing of the production stroke a number of cleaning strokes can be carried out as desired, wherein the plunger 175 rises each time above the cylinder wall and a scraping action is therefore performed on the material in the groove 170 of plunger 175. In practice the number of non-operational strokes is chosen between one and six. During a subsequent production stroke the encapsulating material will be able to flow downward along the plunger wall as far as the groove 170 due to the clearance between cylinder wall and plunger 175 and thereby once again replenish the scraped-off, cured layer in the groove 170. The replenished layer in groove 170 thus forms a sealant between the plunger 175 and the inner wall of the cylinder.

## Claims

1. Apparatus for encapsulating with plastic lead frames carrying chips, comprising mutually movable mould halves (102, 103) which in the closed position bound a mould cavity (133, 145) for receiving a lead frame, a feed runner connecting onto the mould cavity (133, 145) for supplying encapsulating material and a plunger-cylinder (134, 175) connected onto this feed runner for carrying up encapsulating material under pressure, whereby at a distance from the head end of the plunger (134, 175) a peripheral groove (170) is arranged around the plunger and is connected to the head end by means of at least one flow channel (171, 172), **characterized in that**,
the at least one flow channel (171, 172) runs in the outer wall of the plunger (134, 175) along the plunger's longitudinal axis.

2. Apparatus as claimed in claim 1, **characterized in that** the flow channel (171, 172) is of swallowtail shape in cross section.

3. Apparatus as claimed in claims 1-2, **characterized in that** the outer wall of the plunger (134, 175) is provided with helically running grooves and that the depth of the grooves increases as seen from the drive side of the plunger (134, 175).

4. Apparatus as claimed in claims 1-3, **characterized in that** the plunger (134, 175) is connected to a drive (136, 137, 138) by means of welds (176).

## Patentansprüche

1. Anordnung zum Einkapseln mit Kunststoff von Chips tragenden Leiterrahmen, bestehend aus gegenseitig bewegbaren Pressformhälften (102, 103), die in geschlossener Stellung einen Formhohlraum (133, 145) zur Aufnahme eines Leiterrahmens umschließen, einem mit dem Formhohlraum (133, 145) verbundenen Angusskanal für die Zufuhr von Material zum Einkapseln und einem mit diesem Angusskanal verbundenen Druckkolben-Zylinder (134, 175), um Material zum Einkapseln unter Druck zuzuführen, wobei in einem Abstand vom Kopfende des Kolbens (134, 175) eine peripherisch umlaufende Rille (170) um den Kolben angeordnet ist und mit dem Kopfende über mindestens einen Strömungskanal (171, 172) verbunden ist, **dadurch gekennzeichnet, dass** der zumindest eine Strömungskanal (171, 172) in der Außenwand des Kolbens (134, 175) entlang der Längsachse des Kolbens verläuft.

2. Anordnung nach Anspruch 1, **dadurch gekennzeichnet, dass** der Querschnitt des Strömungskanals (171, 172) die Form eines Schwalbenschwanzes aufweist.

3. Anordnung nach Anspruch 1-2, **dadurch gekennzeichnet, dass** die Außenwand des Kolbens (134, 175) mit spiralförmigen Rillen versehen ist und dass die Tiefe der Rillen von der Antriebsseite des Kolbens (134, 175) aus gesehen zunimmt.

4. Anordnung nach Anspruch 1-3, **dadurch gekennzeichnet, dass** der Kolben (134, 175) mit einem Antrieb (136, 137, 138) durch Schweißverbindungen (176) verbunden ist.

## Revendications

1. Dispositif pour enrober dans du plastique des grilles de connexion portant des puces, comprenant des moitiés de moule (102, 103) mobiles l'une par rapport à l'autre qui, lorsqu'elles sont fermées, délimitent une cavité de moule (133, 145) destinée à recevoir une grille de connexion, un canal d'alimentation raccordé à la cavité de moule (133, 145) pour fournir du matériau d'enrobage et un piston plongeur (134, 175) raccordé à ce canal d'alimentation afin de transporter le matériau d'enrobage sous pression, étant entendu qu'à une certaine distance de l'extrémité avant du plongeur (134, 175), une rainure périphérique (170) est agencée autour du plongeur et reliée à son extrémité avant au moyen d'au moins un canal d'écoulement (171, 172), **caractérisé en ce que** le au moins un canal d'écoulement (171, 172) passe dans la paroi externe du plongeur (134, 175) en suivant l'axe longitudinal de celui-ci.

2. Dispositif selon la revendication 1, **caractérisé en ce que** le canal d'écoulement (171, 172) possède une section en forme de queue d'aronde.

3. Dispositif selon les revendications 1 et 2, **caractérisé en ce que** la paroi externe du plongeur (134, 175) est pourvue de rainures hélicoïdales et **en ce que**, vue du côté entraînement du plongeur (134, 175), la profondeur des rainures augmente.

4. Dispositif selon les revendications 1 à 3, **caractérisé en ce que** le plongeur (134, 175) est relié à un entraînement (136, 137, 138) au moyen de soudures (176).
